# EUROPEAN PATENT APPLICATION

(11) **EP 4 742 841 A1**
(43) Date of publication of application: **13.05.2026**
(21) Application number: 24212507.8
(22) Date of filing: 12.11.2024
(51) Int. Cl.: H05K 3/34, H05K 3/12, H05K 1/09, H05K 3/20

(54) **A METHOD FOR TRANSFERRING A FUNCTIONAL MATERIAL**

(71) Applicant: Nederlandse Organisatie voor toegepast- natuurwetenschappelijk onderzoek TNO, 2595 DA 's-Gravenhage (NL)
(72) Inventor: GIESBERS, Merijn Peter, 2595 DA 's-Gravenhage (NL); ARUTINOV, Gari, 2595 DA 's-Gravenhage (NL); FLEDDERUS, Henri, 2595 DA 's-Gravenhage (NL); ROSO CASARES, Sergio, 2595 DA 's-Gravenhage (NL); KARKI, Akchheta, 2595 DA 's-Gravenhage (NL)
(74) Representative: V.O.

(57) **Abstract**

The invention is aimed at providing a transfer method for a functional material (3) onto a receiving substrate (5). The method comprises the steps of: providing a plate (1) including at least one cavity (2), providing a functional material (3) followed by providing at least one coating (4) covering the functional material. Releasing the coated functional material by imparting an energy pulse (6) at the at least one cavity such that the functional material is transferred onto a receiving substrate. (5)

## Description

### TECHNICAL FIELD OF THE INVENTION

The invention relates to a transfer method of a functional material on a receiving substrate.

### BACKGROUND OF THE INVENTION

In order to transfer functional materials such as a viscous material to a receiving substrate from a structured carrier using a laser, a resistive heater, a light source or a heat source, a carrier substrate may be coated or deposited with the functional material wherein the at least one cavity present on the carrier substrate may be filled using for example a squeegee. A typical example to transfer a functional material is when bonding an interconnection of discrete bare chip components of microelectronic components. A proper transfer of the functional material onto a receiving substrate is considered successful when the transfer is sufficiently accurate such that the predominantly miniature electrical or other types of interconnects are adequately bonded to the receiving substrate. In general the functional material is conductive such that electrical connection as well as the fixation may happen concurrently.

Another typical process wherein a transfer of a functional material may be critical is when fixating and/or bonding dies in the semiconductor industry. A conductive material acting as a functional material, generally is referred to as a die attach material in the semiconductor industry, may be preferred as this may facilitate the removability of heat or may benefit the electrical conductivity of the bond between a die and a receiving substrate like for example a PCB-board.

Functional materials often need to be formulated with other materials to increase the printability or coating properties. Often the functional material is combined with a solvent or a liquid such that an ink or a paste is formed. Ideally, a high solid content of the functional material is obtained or only a pure functional material is deposited on a receiving substrate. The high solid content of the ink or paste may accordingly increase the viscosity of the ink or paste possibly limiting a transfer of the functional material.

To attain a sufficient accurate transfer, the tackiness of the functional material is considered a reliable parameter to measure transfer efficiency. Generally, a too low tackiness of the functional material may result in an unacceptable transfer or possibly may result in no transfer of the functional material, hence reducing the efficiency of the transfer process. Additionally, functional materials are regularly encountered with rapid drying due to, for example, the evaporation of a solvent present in the functional material. Consequently, material properties such as tackiness of a dried functional material may be affected and therefore may negatively affect the transfer accuracy and accordingly limit materials that can be used for bonding electrical connections.

Further, some processes may require a stack comprising multiple materials to increase or provide a combination of functionalities. To provide a stack of multiple materials generally multiple prints need to be done. Multiple prints increase the processing time and may reduce to overall yield due to possible misprints or alignment inaccuracies between the different steps.

Examples of transferring functional materials such as viscous materials can be found in US20170275750 and US20230209722. US20170275750 describes a method for transferring a functional material on a substrate using a pulse of light to heat the light absorbing material. US20230209722 describes a transfer method of a highly viscous material, such as a conductive paste, onto a receiving substrate. The transfer is achieved by heating a gas release layer. Both US20170275750 and US20230209722 describe a method for transferring a functional material but are silent about the yield loss and the lower transfer accuracy generally encountered when time progresses resulting in a gradual decline of material properties like for example tackiness of the functional material.

As such, the prior art does not provide an acceptable solution or method to solve the yield loss and/or the decrease in accuracy for transferring a functional material.

### SUMMARY

The present invention is aimed at providing a method for transferring a functional material onto a receiving substrate with an improved yield and/or accuracy. To improve the yield and/or the accuracy, the invention disclosed herein for transferring a functional material onto a receiving substrate is transferred by means of a transfer device comprising: a plate having a cavity surface that includes at least one cavity, the method comprising the steps of: providing the at least one cavity with the functional material such that the at least one cavity is at least partially filled with the functional material. After providing the functional material, at least one coating, suitable for bonding to the functional material, is provided on top of the functional material, forming a coated functional material. The at least one coating may at least cover 50%, preferably 70%, more preferably 90%, and most preferably 100% of the functional material. Following to the deposition of the functional material and the at least one coating, the coated functional material is released from the at least one cavity by imparting an energy pulse provided at the at least one cavity, thereby transferring the functional material onto the receiving substrate. The functional material present on the transfer device is covered by the at least one coating, wherein the at least one coating provides a durable adhesion, when transferred, with the receiving substrate. The at least one coating primarily provides a durable adhesion but may, after bonding, with the receiving substrate provide an additional functionality like for example protection against fluctuating temperatures. Usually, the functional material may have a viscosity of at least 1 Pa.s, preferably at least 10 Pa.s, more preferably at least 15 Pa.s, the viscosity measured according to the Brookfield method at 5rpm and 25 °C.

By covering the functional material with at least one coating, the method according to the invention, has the advantage that the functional material does not desiccate in due time therefore material properties like for example tackiness remain stable over time. The at least one coating may be chosen in such a way that it does not easily dry over time and retains its tackiness. Accordingly, the accuracy and/or yield, when transferring the functional material onto the receiving substrate, may be preserved over time.

In particular, the method according to the invention describes a method suitable for transferring a functional material over a period of time, preferably the period of time may be at least 15 minutes, more preferably at least 30 minutes, most preferably at least 60 minutes.

In a further embodiment, the functional material may be transferred onto the receiving substrate such that the at least one coating may form an interface layer between the functional material and the receiving substrate. As such the interface layer may provide additional functionalities comprising of improved wettability to the receiving substrate, improved conductivity, insulation, chemical resistance, vibration dampening, compressibility, stretchability, flexibility, coefficient of thermal expansion, recyclability, protection, degradation resistance, wavelength absorptivity, reflectivity, transmittance or any combination thereof.

The additional functionalities may provide the functional material with the appropriate properties such that the functional material may be used in applications previously not envisaged or difficult to achieve due to lack in transfer accuracy as multiple printing steps may need to be done to include a new functionality. Additionally, in conventional methods, specific compositions of the functional material may need to be designed such that the right properties may be encompassed increasing the lead time for new developments and possibly restrict new innovations.

In another embodiment, the bond formed between the at least one coating and the receiving substrate may be determined by evaluating specific material properties such as a tack-value, tensile strength, die shear strength when used for bonding dies, coating adhesion testing using knife/tape methods. Preferably, the material property may be evaluated using tackiness or tack-value measured according to ASTM D2979.

Typically, the tack value of the functional material gradually may reduce in time to below 70% of the initial tack value, thereby reducing the accuracy of the transfer and as such may decrease the yield of the transfer. Providing at least one coating that may be less susceptible to a decrease in material properties may increase the accurateness when transferring the functional material onto the receiving substrate.

In yet another embodiment, the functional material may be transferred after at least 15 min, preferably after at least 30 min, more preferably after at least 60 min.

In a further embodiment, the at least one coating may not interfere with the functional material. Generally, this may indicate that the at least one coating may not substantially affect material properties such as thermal or electrical conductivity of the functional material such that the overall properties of the functional material may be guaranteed during further processing of the functional material. Typically, the material property of the functional material in combination with the at least one coating may be minimal 60% of the initial value obtained when solely measuring the functional material, hence without the at least one coating. For conductive material the material property typically may be thermal conductivity or electrical resistivity..

In a further embodiment, the functional material may comprise a solder paste, a conductive material such as a conductive adhesive, a tacky flux, a dielectric material, a metallic ink, a conductive ink, a silicone, a underfill material, a solvent, a graphic ink, or any combination thereof. Typically, the functional material may be a conductive material, preferably the conductive material may be selected from the group consisting from a solder paste, a conductive adhesive a metallic ink, a conductive ink, or a combination thereof.

In yet another embodiment, the at least one coating may be selected from an adhesive, diluent, a solder paste, a conductive material such as a conductive adhesive or a conductive ink, a tacky flux, a dielectric material, a metallic ink, a silicone, a underfill material, a solvent, a graphic ink, or any combination thereof. Preferably, the at least one coating may comprise a tacky flux. In general, a thickness of the at least one coating may be in the range of 0.1 - 100 µm.

In a further embodiment, the at least one coating may be removed after the functional material is transferred to the receiving substrate typically this may happen during further processing of the functional material. A typical example may be exposing the functional material to a temperature of at least 200 °C thereby either incinerating the at least one coating or dissolving the at least one coating into the functional material such that further processing of the functional material may be facilitated.

In another embodiment, the transfer means suitable for imparting an energy impulse may be selected from the group consisting of a laser, a heat source, a light source, or UV-source.

In a further method embodiment, the at least one cavity in the plate may be 1 - 1000 µm deep and may have a smallest diameter in a range between 1 and 5000 µm.

Additionally, the invention is aimed at a transfer device for transferring a functional material onto a receiving substrate, the transfer device comprising: a plate having a cavity surface that includes at least one cavity. The functional material at least partially, preferably fully is covered with at least one coating. Subsequently, the at least one coating, when imparted by an energy pulse at the at least one cavity, provides a durable adhesion with the receiving substrate such that the functional material is at least partially released from the at least one cavity onto the receiving substrate.

In a further embodiment, the at least one cavity may further comprise a release layer before providing the at least one cavity with the functional material.

### BRIEF DESCRIPTION OF DRAWINGS

These and other features, aspects, and advantages of the apparatus, systems and methods of the present disclosure will become better understood from the following description, appended claims, and accompanying drawing wherein:
Figure 1A displays a transfer device comprising a plate having one cavity and a functional material.
Figure 1B displays a transfer device as depicted in figure 1A further comprising the at least one coating.
Figure 2 illustrates a method for transferring a functional material by imparting an energy pulse at the at least one cavity.
Figure 3 depicts the method of providing a transferring a functional material onto a receiving substrate.
Figure 4 illustrates a functional material comprising 2 coatings.
Figure 5 displays a transfer device further comprising a release layer.
Figure 6 depicts a transfer device comprising a plurality of cavities filled with a functional material that selectively may be transferred onto a receiving substrate.
Figure 7 illustrates an embodiment wherein the at least one coating may be removed after further processing of the functional material.
Figure 8 displays an embodiment wherein the at least one coating may dissolve into the functional material after further processing of the functional material.
Figure 9 depicts an embodiment wherein the at least one coating forms an interface after further processing of the functional material.

### DESCRIPTION OF EMBODIMENTS

Terminology used for describing particular embodiments is not intended to be limiting of the invention. As used herein, the singular forms "a", "an" and "the" are intended to include the plural forms as well, unless the context clearly indicates otherwise. The term "and/or" includes any and all combinations of one or more of the associated listed items. It will be understood that the terms "comprises" and/or "comprising" specify the presence of stated features but do not preclude the presence or addition of one or more other features. It will be further understood that when a particular step of a method is referred to as subsequent to another step, it can directly follow said other step or one or more intermediate steps may be carried out before carrying out the particular step, unless specified otherwise. Likewise it will be understood that when a connection between structures or components is described, this connection may be established directly or through intermediate structures or components unless specified otherwise.

As used herein, the term "tackiness" or "tack value", refers to a property of a material to instantly adhere to a substrate with a minimum application pressure and time. Typically, the pressure is below 0.1 N and applied for maximum 1s. The tackiness or tack value, described all through the application, is measured according to ASTM D2979 unless otherwise specified.

As used herein, the term "desiccation", refers to the process of when a material or substance dries out in the course of time. Typically a material may be considered to be drying when a solvent or low volatile organic compound evaporates. Examples of a solvent may be an organic solvent or water. Desiccation may result in a reduction or even a complete loss of certain material properties such as tackiness, volume, viscosity, and other mechanical properties. Throughout the application, a substance or material is referred to as desiccated when a material property like for example tackiness reaches 70% of its initial value.

As used herein, the term "durable adhesion", refers to a material that maintains its adhesion properties over time. Typically, adhesion properties may be measured by evaluating a tack value or adhesion towards a substrate. Further, the term durable refers to when a material property does not decrease below 70%, preferably 80%, more preferably 90% of the initial measured value of the selected material property like for example tack value, wherein the initial measured value like tack-value is the initial value measured 5 min after depositing the at least one coating on top of a functional material. Therefore, a material property may considered stable when the selected material property does not decrease below 70% of its initial value. Typically, the material may be stable for, but not limited to, at least 15 min, preferably at least 30 min, more preferably at least 60 min, most preferably at least 120 min. In certain embodiments, the functional material may be deposited 24h before transferring.

The invention is described more fully hereinafter with reference to the accompanying drawings, in which embodiments of the invention are shown. In the drawings, the absolute and relative sizes of systems, components, layers, and regions may be exaggerated for clarity. Embodiments may be described with reference to schematic and/or cross-section illustrations of possibly idealized embodiments and intermediate structures of the invention. In the description and drawings, like numbers refer to like elements throughout. Relative terms as well as derivatives thereof should be construed to refer to the orientation as then described or as shown in the drawing under discussion. These relative terms are for convenience of description and do not require that the system be constructed or operated in a particular orientation unless stated otherwise.

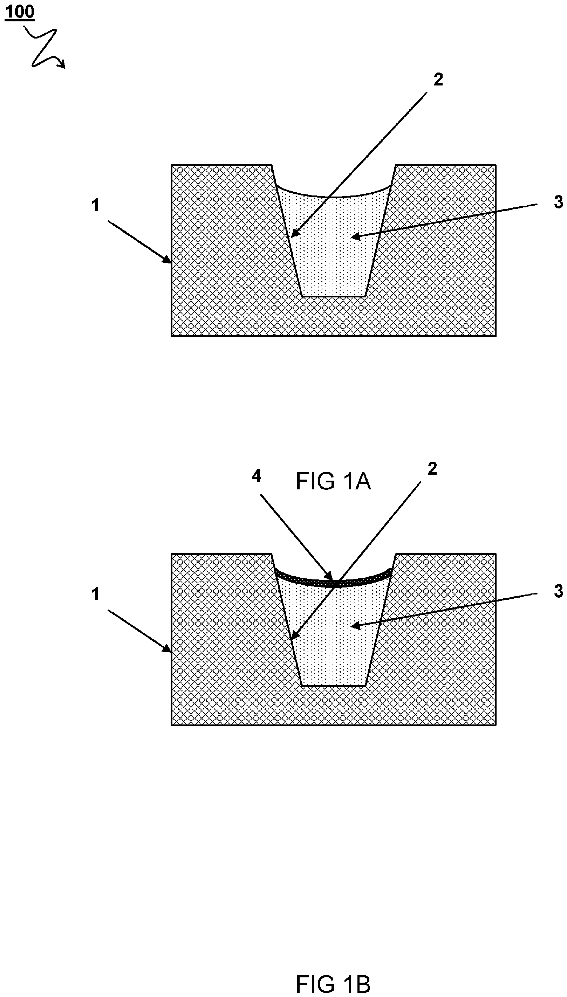

In an aspect, a method for transferring a functional material onto a receiving substrate is provided. The method allowing for an improved yield and/or accuracy as material properties such as tackiness are stable over time contrary to conventional transferring methods described in the prior art. Therefore, figure 1A displays a transfer device 100 comprising a plate 1 including at least one cavity 2 provided with a functional material 3. The functional material 3 may be provided by depositing the functional material 3 onto the plate 1 and subsequently may at least partially fill into the at least one cavity 2 using a squeegee or a similar instrument suitable for applying the functional material. Preferably the functional material fills at least 50%, more preferably at least 70%, even more preferably at least 80%, and most preferably at least 90% of the cavity. When the functional material 3 has been provided into the at least one cavity 2, the at least one coating 4 is deposited and wiped out onto the plate 1 comprising the functional material 3 such that the at least one coating covers the functional material 3 present in the at least one cavity 2 as is depicted in figure 1B. The at least one coating 4 may be provided in a similar manner as the functional material 3.

Generally, the functional material may comprise a solder paste, a conductive material such as a conductive adhesive or a conductive ink, a tacky flux, a dielectric material, a metallic ink, a silicone, a underfill material, a solvent, a graphic ink, or any combination thereof. In a preferred embodiment the functional material may be a conductive material. A conductive material may be any material suitable for transferring heat or electrical signals from a die to a receiving substrate 5. Typically, a conductive material may have a thermal conductivity of at least 0.5 W m⁻¹ ·K⁻¹ and/or an electrical resistivity of below 1 Ω ·m.

Additionally, the at least one coating covering the functional material may comprise of a solder paste, a conductive material such as a conductive adhesive or a conductive ink, a tacky flux, a dielectric material, a metallic ink, a silicone, a underfill material, a solvent, a graphic ink, or any combination thereof. The at least one coating may be chosen in such a way that the material properties do not degrade or decrease over time, preferably the material properties do not decrease after 15 min, more preferably after 30 min, most preferably after 60 min. Generally, the material property may be selected from tackiness, viscosity, density, solid content, electrical conductivity, heat conductivity, rheological properties, preferably the material property may be tackiness or tack-value measured according to ASTM D2979. The tack-value may give proper insights into the possibilities of forming a bond to a receiving substrate over a course of time. Overall, the at least one coating may be considered as having stable material properties such as tack-value when, over time the material property does not decrease below 50%, preferably 60%, more preferably 70%, even more preferably 80%, most preferably 90% of the initial measured value of the selected material property like for example tack value, wherein the initial measured value like tack-value is the value measured 5 min after depositing the at least one coating on top of a functional material. A reduction of tack-value below 50% may result in a decreased yield and/or lower accuracy and therefore may end in a less efficient transfer process. A common example of the at least one coating may be a tacky flux. A flux is mainly provided into a conductive material such as a solder paste to enhance the soldering process. Primary, the flux may be utilized to remove oxidized metals, secondary the flux may improve flowability of the conductive material such that the wettability to the receiving substrate may increase, ultimately strengthen the bond between the functional material and the receiving substrate 5.

In a first embodiment, the at least one coating 4 may provide an adequate adhesion to the receiving substrate and may not bounce upon transferring therefore providing an accurate transfer over time.

In a second embodiment, the at least one coating 4, may protect the functional material from elements such as air or light which may negatively affect the functional material 3 as a result of evaporation or oxidation and thus reduce the functionality of the functional material 3.

In a third embodiment, the at least one coating 4 may match the Coefficient of Thermal Expansion (CTE) between the receiving substrate 5 and the functional material such that the probability of delamination may reduce when exposing the bond to fluctuating temperatures.

In a fourth embodiment, the at least one coating 4 may optimize or tune a surface tension between the receiving substrate 5 and the functional material. Accordingly, the at least one coating 4 may improve wetting and hence the adhesion to the receiving substrate 5. Additionally, in the occasion that the at least one coating 4 may be used to tune the surface tension, the at least one coating 4 may be intended for fluidic self-assembly. Accordingly, the at least one coating may act as a interfacial layer between the functional material 3 and the receiving substrate 5 and therefore may enable automatic fine-tuning of the placement accuracy of the functional material 3 through surface tension driven forces, guided by features on the receiving substrate 5. Tuning the surface tension may have the advantage of highly accurate alignment like for example below 1-3 µm precision which may be difficult to reach using a regular transfer method. The improved alignment accuracy may be required in for example future generation microLEDs where the alignments are projected to measure 5 µm. Another example may be encountered in photonic chip integration as an accuracy for positioning a chip may be less than 500 nm, possibly below 200 nm, similar to the future generation of microLEDs, photonic chip integration may benefit from a tuned surface tension material resultant in fluidic self-assembly.

In a fifth embodiment, the at least one coating may be an optical material such that optical features like for example a microlens may be included as functional material. A typical example of an optical material may be an absorption or reflection of a specific wavelength range. The advantage of absorbing or reflecting a specific wavelength may be to prevent degradation of the functional material when subjected to said specific wavelength range or by ensuring that non-desirable wavelengths may not reach specific areas such as seen in medical applications. Another example of an optical material may be a material providing a reduction or possibly even eliminates reflection of a specific wavelength, typically referred to as an anti-reflection coating by optical density tuning. Providing an anti-reflection wavelength as the at least one coating may have the benefit of reducing the reflection at the interface of the functional material, here an optical element, thereby increasing the transmission for the desired wavelength range. A further example may be related to a functional material wherein both the functional material 3 and the at least one coating 4 are optically transparent and may have a different refractive index like for example in applications comprising a doublet microlens array. Choosing the surface tension and viscosity of the functional material 3 and the at least one coating 4, may allow for an improved control of the curvature during the deposition of the functional material. This improvement may allow for optimized lens shapes, which may be critical for improving imaging quality and correcting optical aberrations. Additionally, a precise control of the speed, pressure, viscosity or any combination thereof of the functional material 3 and the at least one coating 4 may allow for adjustments of the ratio and/or a resulting shape of the portions of a functional material 1 and the at least one coating 4 ensuring that lenses meet the specific optical requirements for their intended applications such as improved light focusing and transmission. This may enable the fabrication of a doublet microlens (array) on a larger scale. Compared to singlet lenses, doublet lenses, using by virtue two materials that may have a different refractive index, may have the advantage of better correcting for optical aberrations resulting in higher quality imaging and as such may make doublet microlens arrays a better fit for applications requiring precision optics or may allow for an improved fine tuning for specific wavelengths which may enable applications such as infrared imaging and UV-filtering.

In a sixth embodiment, the at least one coating may 4 act as an adhesive, an adhesive such as a pressure sensitive adhesive may have the benefit of ensuring a proper bond between the functional material 3 and the receiving substrate 5 as adhesive may ensure a stable bond over time. An example of an adhesive may be a conductive adhesive, a conductive adhesive may combine the required mechanical strength with the proper electrical connection and/or sufficient heat dissipation. Additionally, the adhesive may be a reversible adhesive such that recyclability, repairability may be enhanced. Typical reversible adhesive may be triggered by heat, UV, electricity, water or solvent such that upon activating the trigger the adhesion may be reduced or completely de-activated. The reduction of deactivation of the adhesive may allow for easy removal of the functional material 3 and/or the at least one coating 4 as well as any component adhered to the functional material 3 and/or at least one coating 4 such that an efficient recycling or repair may be enabled. A benefit of using a reversible adhesive may be the recycling of both the functional material 3n the at least one coating 4 and any component that may be bonded to the functional material. Additionally, a reversible adhesive may facilitate repairability as components may be more easily disassembled. An example of an application that may benefit from a reversible adhesive may be in an electronic device allowing recyclability of valuable components and therefore enhancing the sustainability and/or reducing the overall cost of the electronic device. Another example may be a 2-component adhesive comprising a first and a second component wherein the functional material 3 may act as a first component of the 2-component adhesive while the at least one coating 4 may act as the second component of the 2-component adhesive or vice versa. The curing of the 2-component adhesive may be initiated by the energy source 6 provided during the transfer or afterwards by providing the required heat or light. Using the method according to the invention for a 2-component adhesive may have the benefit of more easily positioning 2 components on top of each other and hence improving accuracy and/or enabling the deposition of two small dots.

In a seventh embodiment, the at least one coating 4 may act as a thermal barrier or as a shield between the receiving substrate 5 and the functional material 3. The at least one coating 4 may act as a thermal barrier when the at least one coating may 4 have a lower thermal conductivity compared to the functional material 3. Advantageously, the at least one coating 4 may control the temperature gradient between the functional material 3 and the receiving substrate 5 which may be encountered when exposing the functional material and the receiving substrate 5 to fluctuating conditions like for example varying temperatures, intermittent irradiation of light and/or heat. A thermal barrier may have the advantage of avoiding said undesired fluctuating conditions and consequently may increase the durability of the end-product or may enhance the quality of the sensor readout.

Alternatively, the at least one coating 4 may act as a conductor between the functional material 3 and the receiving substrate 5. Providing a conductor as the at least one coating 4 may be beneficial when a good thermal interface may be required which may not be attained by the functional material 3. A common example may be a bond between a thermal sensor and the top of the functional material 3. Oppositely, the at least one coating 4 may behave as an isolator such that an electrical isolation may be achieved between the functional material 3 and the receiving substrate 5, this to ensure that two conducting surfaces are not connected possibly forming an electrical short cut.

Alternately, the at least one coating 4 may operate as a vibration dampening material between the functional material 3 and the receiving substrate 5. Applying a vibration dampening material may absorb vibrations as a result of an application. Vibrations may negatively affect the performance of the functional material 3 or a structure placed on top of the functional material 3 (e.g. a chip, sensor, LED, electrical component).

In a further embodiment, the at least one coating 4 may function as a chemically and/or corrosion resistant material, consequently the functional material 3 may be protected from chemical process steps potentially needed before transferring the functional material. Known chemical processes may be edging were undesired materials may be removed. Furthermore, the functional material 3 may function as a chemically and/or corrosion resistant material for the at least one coating 4.

In yet a further embodiment, the at least one coating 4 may serve as a flexible, stretchable, compressible, or any combination thereof material such that the at least one coating 4 may act as a mechanical buffer. A flexible, stretchable or compressible material may have the advantage of an improved adhesion and/or may reduce delamination of components in applications where flexible substrates may be used. A known example of a flexible substrate may be a flexible display.

In another embodiment, the at least one coating 4 may reduce the overall cost of the functional material by reducing the amount of an expensive functional material 3 and replacing it with the at least one coating 4 having a lower cost compared to the functional material.

In an even further embodiment, the functional material may be a silicone such that the functional material 3 may protect the at least one coating 4 from degradation like for example oxidation, mechanical abrasion or influences related to humidity after depositing the functional material.

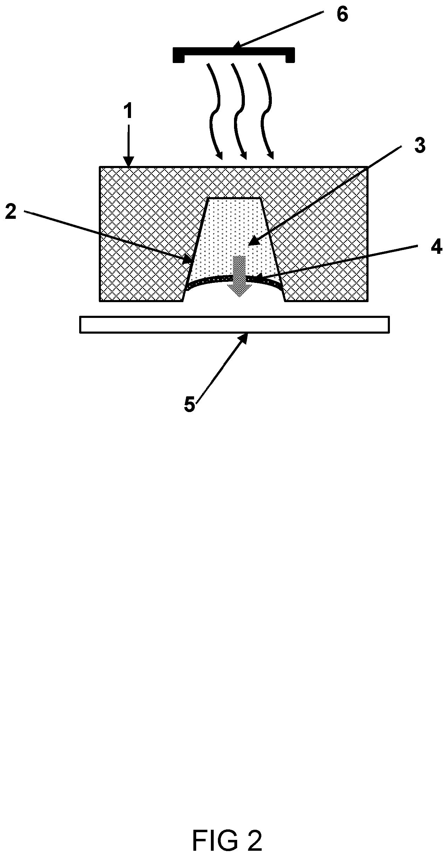

Figure 2 illustrates how a functional material comprising the functional material 3 and the at least one coating 4, is transferred onto a receiving substrate 5 by imparting an energy pulse 6 at the at least one cavity 2. Once the energy pulse 6 is imparted, a release mechanism is triggered such that functional material may be discharged onto the receiving substrate 5. Typically, the energy pulse 6 may result in heating the functional material such that a gas may be generated at the interface between the at least one cavity 2 and the functional material, the generated gas may provide the required pressure to transfer/discharge the functional material onto the receiving substrate 5. The energy pulse 6 may be provided by a laser, a heat source, a UV-light depending on the release mechanism included in the transfer device 100 or the functional material. Typically, the energy pulse 6 may trigger the release mechanism resulting in the transfer.

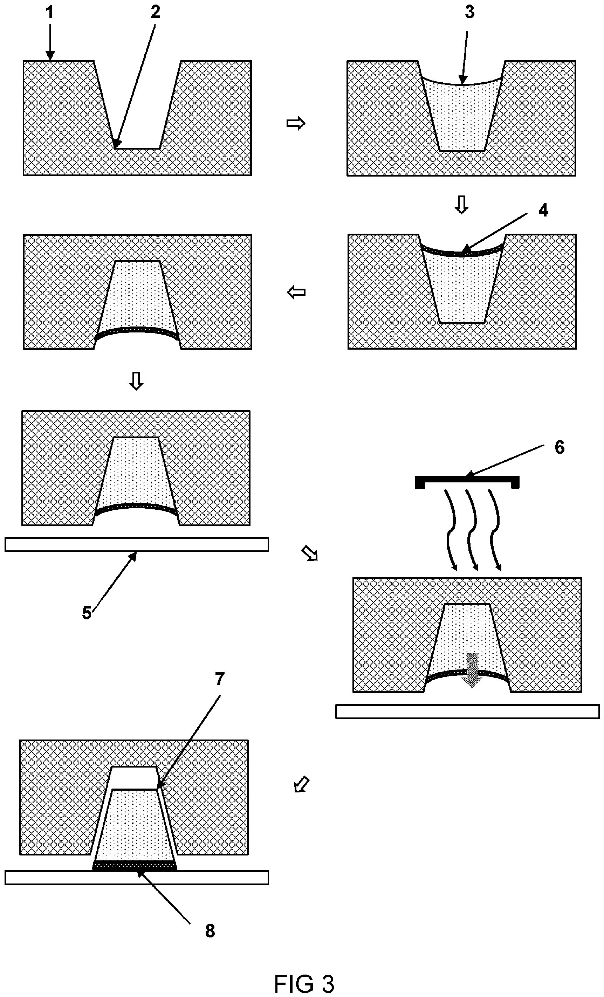

Figure 3 shows a schematic representation of the method according to the invention, the method comprises the subsequent steps of providing a plate 1 including at least one cavity 2, depositing a functional material 3 in the at least one cavity 2, depositing the at least one coating 4 on top of the functional material 3 such that the functional material 3 is covered by the at least one coating 4, revolving the plate upside down, providing a receiving substrate 5, imparting an energy impulse 6 at the at least one cavity 2 such that the functional material is transferred to the receiving substrate 5. In general, the energy pulse may be any energy source known to date such as heat, a laser, light, or any combination thereof. Furthermore, upon transferring the functional material onto the receiving substrate 5, the functional material may form a 2-layer construction comprising the at least one coating and the functional material. The at least one coating may provide additional functionalities for further processing and/or may foresee additional functionalities during the lifetime of an application. Typical functionalities may comprise improved wettability to the receiving substrate, improved conductivity, insulation, chemical resistance, vibration dampening, compressibility, stretchability, flexibility, coefficient of thermal expansion, recyclability, protection, degradation resistance, wavelength absorptivity, reflectivity, transmittance or any combination thereof.

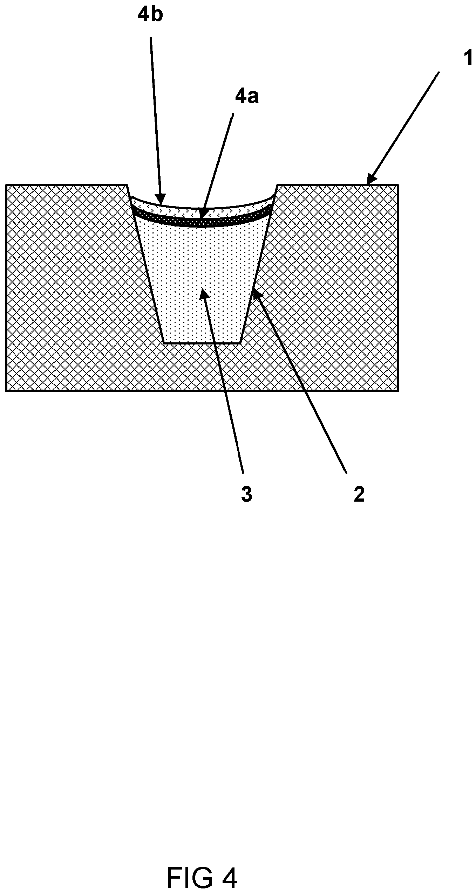

In figure 4 an embodiment is shown wherein the functional material 3, deposited into the at last one cavity 2, may be provided with more than 1 coating like for example two coatings 4a, 4b such that more than one additional functionality may be anticipated. A combination of functionalities may for example by a chemical resistant coating 4b combined with an optical coating 4a. Accordingly, the functional material 3 may be resistant to chemicals as well as protected from specific wavelengths which may degrade the functional material 3.

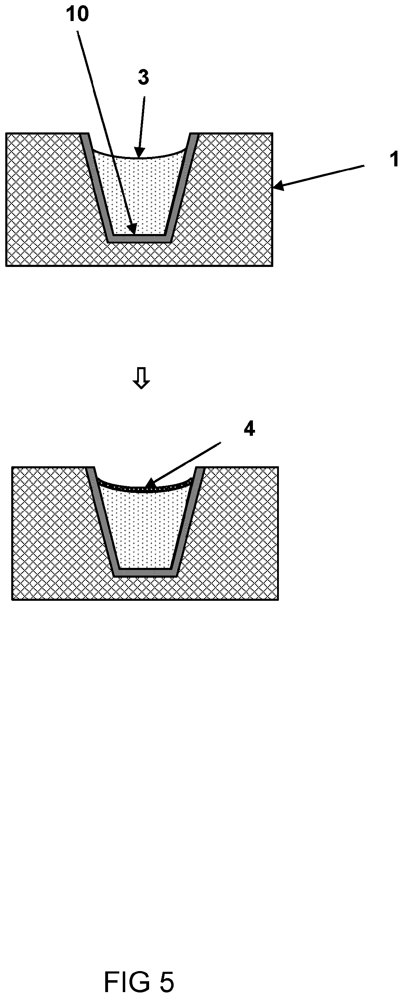

Figure 5 illustrates an embodiment wherein a plate 1 including at least one cavity 2 may be covered with a release layer 10 before depositing a functional material 3. Providing a release layer 10 may have the advantage of enhancing the transfer of the functional material as the release layer 10 may be optimized for a specific energy pulse (not shown) required to release the functional material onto a receiving substrate (not shown). Examples of a release layer 10 may comprise a resistive layer, a light-absorbing layer or a dynamic release layer which upon imparting a proper energy impulse may activate the release layer and hence trigger the transfer of the functional material.

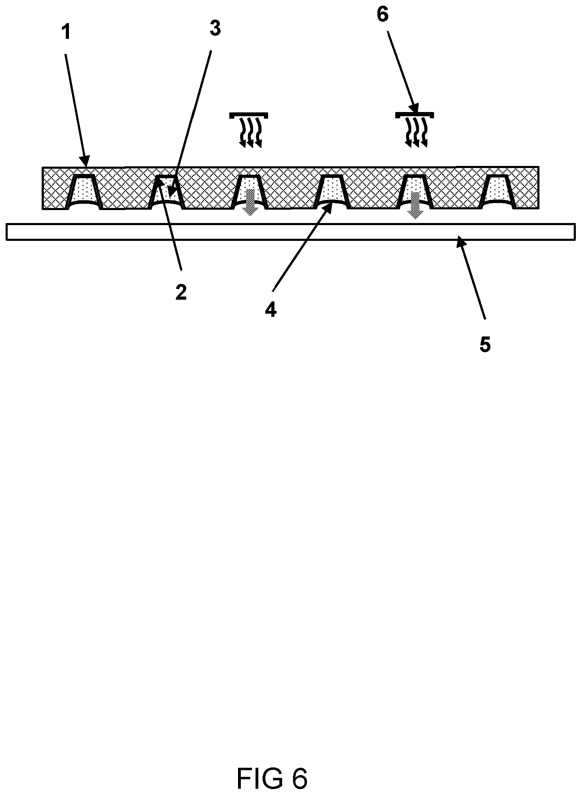

Figure 6 depicts a plate 1 including more than one cavity 2, here six cavities, which will be deposited with a functional material 3, followed by at least one coating 4. The deposition of the functional material 3 and the at least one coating 4 may be applied using a squeegee. The functional material 3 and the at least one coating 4 may selectively be released by imparting an energy pulse 6 at a cavity 2 such that the functional material may be transferred to a receiving substrate 5. The energy pulse may be supplied by a stand-alone device oriented to the transfer device or may be incorporated into the transfer device. Generally, when the energy pulse is a heat source supplied by a resistive heater, the resistive heater may be built into to the transfer device. As aforementioned, the functional material may be released by any known energy pulse suitable for activating a release mechanism.

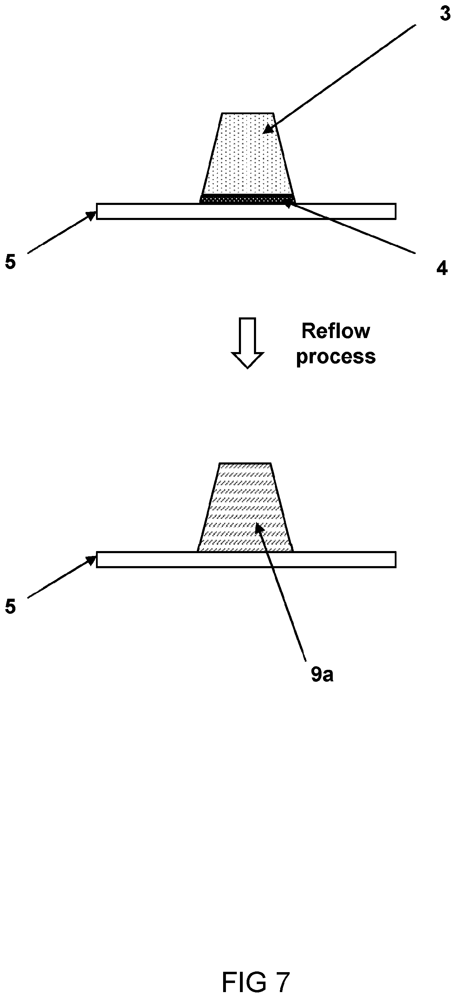

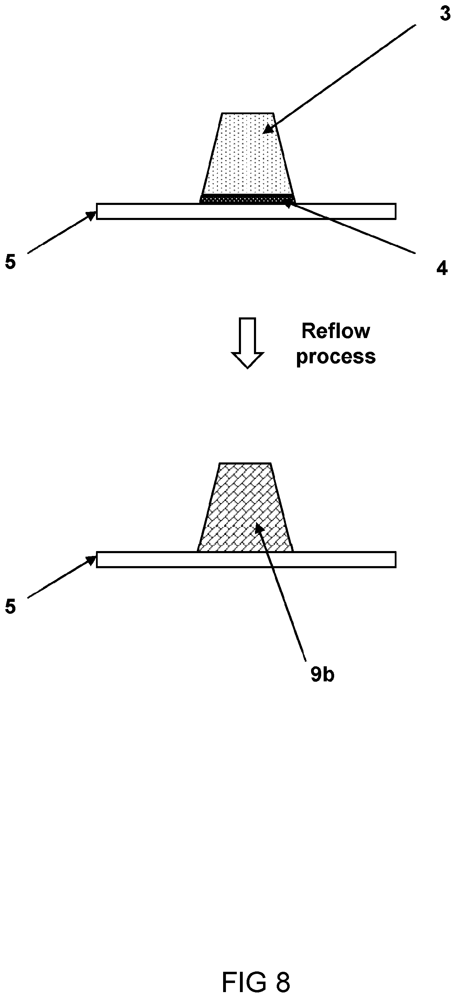

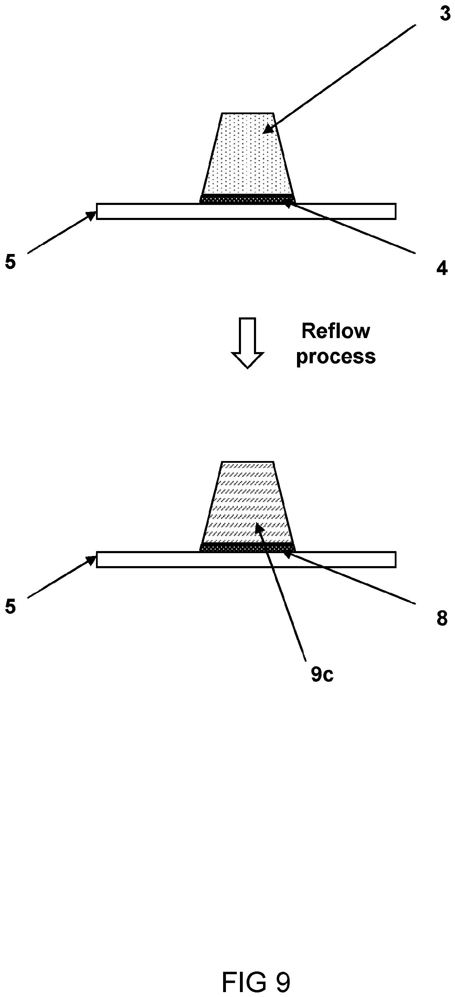

Figures 7-9, illustrate how the functional material may function differently after further processing. The function may depend on the at least one coating covering the functional material. In a typical embodiment as displayed in figure 7, the at least one coating may be removed after exposing the at least one coating to a process that may result in the removal of the at least one coating 4. Typical examples may be evaporation of the at least one coating 4, exposing the at least one coating 4 to a temperature above the a decomposition temperature, or any other process known by the skilled person to remove a coating. Figure 7 shows how a functional material, comprising a functional material 3 and at least one coating 4, may change upon exposure to a high temperature such as anticipated in a reflow process. Exposing the functional material to for example a reflow process may result in removing the at least one coating 4 and further may cure the functional material 3 forming a cured functional material 9a. In another embodiment the at least one coating may dissolve into the functional material such that the at least one coating may facilitate the soldering after exposing the functional material to a temperature of at least 200°C. After exposing the functional material comprising a functional material 3 and the at least one coating 4 to high temperature, thereby dissolving the at least one coating 4, may result in curing the functional material such that a cured functional material 9b may be formed. A typical example of such a coating may be a tacky flux material known for enhancing the flow and removing oxidized metals. Figure 9 shows in embodiment wherein the at least one coating 4 may act as an interface layer 8 in the final application and therefore may provide additional functionalities like for example recyclability, protection, improved wettability. After subjecting the functional material comprising a functional material 3 and the at least one coating 4 to a high temperature, the functional material 3 and the at least one coating 4 may cure forming an interface layer 8 and a cured functional material 9c.

For the purpose of clarity and a concise description, features are described herein as part of the same or separate embodiments, however, it will be appreciated that the scope of the invention may include embodiments having combinations of all or some of the features described. For example, while embodiments were shown for functional materials typically used in the semiconductor industry, also alternative ways may be envisaged by those skilled in the art having the benefit of the present disclosure for achieving a similar function and result. The various elements of the embodiments as discussed and shown offer certain advantages, such as improved efficiency and/or efficacy. Of course, it is to be appreciated that any one of the above embodiments or processes may be combined with one or more other embodiments or processes to provide even further improvements in finding and matching designs and advantages. It is appreciated that this disclosure offers particular advantages to improved stability of the functional material, and in general can be applied for any application wherein materials may need to be transferred to an acceptor substrate.

In interpreting the appended claims, it should be understood that the word "comprising" does not exclude the presence of other elements or acts than those listed in a given claim; the word "a" or "an" preceding an element does not exclude the presence of a plurality of such elements; any reference signs in the claims do not limit their scope; several "means" may be represented by the same or different item(s) or implemented structure or function; any of the disclosed devices or portions thereof may be combined together or separated into further portions unless specifically stated otherwise. Where one claim refers to another claim, this may indicate synergetic advantage achieved by the combination of their respective features. But the mere fact that certain measures are recited in mutually different claims does not indicate that a combination of these measures cannot also be used to advantage. The present embodiments may thus include all working combinations of the claims wherein each claim can in principle refer to any preceding claim unless clearly excluded by context.

## Claims

1. A method for transferring a functional material onto a receiving substrate by means of providing a transfer device for transferring the functional material onto the receiving substrate, said transfer device comprising: a plate having a cavity surface that includes at least one cavity, the method comprises:
a. providing the at least one cavity with the functional material such that the at least one cavity is at least partially filled with the functional material;
b. providing at least one coating, suitable for bonding to the functional material, on top of the functional material;
c. releasing the coated functional material from the cavity by imparting an energy pulse provided at the at least one cavity, such that the functional material is transferred onto the receiving substrate;
wherein the at least one coating provides a durable adhesion, with the receiving substrate, when transferred.

2. The method according to claim 1, wherein the at least one coating forms an interface layer between for the functional material and the receiving substrate.

3. The method according to claim 2, wherein the interface layer provides for additional functionalities comprising of improved wettability to the receiving substrate, improved conductivity, insulation, chemical resistance, vibration dampening, compressibility, stretchability, flexibility, coefficient of thermal expansion, recyclability, protection, degradation resistance, wavelength absorptivity, reflectivity, transmittance or any combination thereof.

4. The method according to any of claims 1-3, wherein the bond between the at least one coating and the receiving substrate is determined by a tack-value, wherein the tack value in due time is at least 70% of the initial tack value, the tack value measured according to ASTM D2979 .

5. The method according to any of claims 1-4, wherein the functional material is transferred after at least 15 min, preferably after 30 min, more preferably after 60 min.

6. The method according to claim any of claims 1-5, wherein the at least one coating does not interfere with the functional material.

7. The method according to any of the claims 1-6, wherein the functional material has a viscosity of at least 1 Pa.s measured according to the Brookfield method at 5rpm and 25 °C.

8. The method according to any of claims 1-7, wherein the transfer means is selected from the groups consisting of a laser, heat, UV or light.

9. The method according to any of claims 1-8, wherein the functional material comprises a solder paste, a conductive adhesive, a tacky flux, a dielectric material, a metallic ink, a conductive ink, a silicone, an underfill material, a solvent, a graphic ink, or any combination thereof.

10. The method according to any of claims 1-9, wherein the functional material is a conductive material, preferably the conductive material is selected from the group consisting from a solder paste, a conductive adhesive, a metallic ink, a conductive ink, or a combination thereof.

11. The method according to any of claims 1 - 10, wherein the at least one coating is selected from an adhesive, diluent, a solder paste, a conductive material such as a conductive adhesive or a conductive ink, a tacky flux, a dielectric material, a metallic ink, a silicone, a underfill material, a solvent, a graphic ink, or any combination thereof.

12. The method according to claim 11, wherein the at least one coating comprises a tacky flux.

13. The method according to any of claim 1 or claim 2, wherein the at least one coating is removed after the functional material is transferred to the receiving substrate..

14. The method according to any of claims 1 - 13, wherein the at least one cavity is 1 - 1000 µm deep and has a smallest diameter in a range between 1 and 5000 µm.

15. The method according to any of claims 1 - 14, wherein the thickness of the at least one coating is in the range of 0.1 - 100 µm.

16. A transfer device for transferring a functional material onto a receiving substrate, comprising:
a. a plate having a cavity surface that includes at least one cavity; wherein the at least one coating covers the functional material; and wherein the at least one coating, by imparting an energy pulse at the at least one cavity, provides a durable adhesion with the receiving substrate such that the functional material is at least partially released from the at least one cavity onto the receiving substrate.

17. The device according to claim 16, wherein the at least one cavity further comprises a release layer.
